# EUROPÄISCHE PATENTSCHRIFT

(11) **EP 1 198 799 B1**
(45) Veröffentlichungstag und Bekanntmachung des Hinweises auf die Patenterteilung: **23.02.2005**
(21) Anmeldenummer: 00927161.0
(22) Anmeldetag: 08.05.2000
(51) Int. Cl.: H01B 1/12, H05K 3/42, C08G 61/12

(54) **VERFAHREN ZUR HERSTELLUNG VON PI-KONJUGIERTEN POLYMEREN**
METHOD OF PRODUCING PI-CONJUGATED POLYMERS
PROCEDE POUR PRODUIRE DES POLYMERES PI-CONJUGUES

(30) Priorität: 20.05.1999 DE 19923140; 06.07.1999 DE 19931114
(43) Veröffentlichungstag der Anmeldung: 24.04.2002
(73) Patentinhaber: Bayer Aktiengesellschaft, 51368 Leverkusen (DE)
(72) Erfinder: GROENENDAAL, Lambertus, B-9112 Sinaai (BE); JONAS, Friedrich, D-52066 Aachen (DE); PIELARTZIK, Harald, D-47800 Krefeld (DE); RITTER, Helmut, D-42111 Wuppertal (DE); STORSBERG, Joachim, D-55286 Wörrstadt (DE)
(86) Internationale Anmeldenummer: PCT/EP2000/004107
(87) Internationale Veröffentlichungsnummer: WO 2000/072331

(56) Entgegenhaltungen:
- US-A- 5 194 313
- US-A- 5 403 467
- CHANE-CHING, KATHLEEN I. ET AL: "Electropolymerization of hydrophobic dipyrrolyls in aqueous medium based on inclusion chemistry" J. MATER. CHEM. (1999), 9(5), 1065-1070 , 18. Mai 1999 (1999-05-18), XP000860715
- LAGROST, C. ET AL: "Host-guest complexation: a new strategy for electrodeposition of processable polythiophene composites from aqueous medium" CHEM. COMMUN. (CAMBRIDGE) (1998), (4), 489-490 , XP002144876 in der Anmeldung erwähnt

## Beschreibung

Die Erfindung betrifft die Herstellung von π-konjugierten Polymeren mit hoher elektrischer Leitfähigkeit durch chemische Oxidation der komplexierten monomeren Verbindungen gemäß Anspruch 1 und ein Verfahren zur Herstellung von durchkontaktierten Leiterplatten und Multilayern.

Die Verbindungsklasse der π-konjugierten Polymeren war in den letzten Jahrzehnten der Gegenstand zahlreicher Veröffentlichungen. Sie werden auch als leitfähige Polymere oder als synthetische Metalle bezeichnet.

Wegen der erheblichen Delokalisierung der π-Elektronen entlang der Hauptkette zeigen diese Polymere interessante (nichtlineare) optische Eigenschaften und nach Oxidation oder Reduktion stellen sie gute elektronische Leiter dar. Dadurch werden diese Verbindungen voraussichtlich eine führende und aktive Rolle auf verschiedenen praktischen Anwendungsgebieten übernehmen, wie z.B. in der Datenspeicherung, der optischen Signalverarbeitung, der Unterdrückung elektromagnetischer Störungen (EMI) und der Sonnenenergieumwandlung, sowie in wiederaufladbaren Batterien, lichtemittierenden Dioden, Feldeffekttransistoren, Leiterplatten, Sensoren und antistatischen Materialien.

Beispiele für bekannte π-konjugierte Polymere sind Polypyrrole, Polythiophene, Polyaniline, Polyacetylene, Polyphenylene und Poly(p-phenylen-vinylene). Sie können durch verschiedene chemische und elektrochemische Polymerisationstechniken hergestellt werden (Stenger-Smith, J.D. *Prog. Polym.* Sci. 1998, 23, 57-79, Feast, W.J.; Tsibouklis, J.; Pouwer, K.L.; Groenendaal, L.; Meijer, E.W. Polymer 1996, 37, 5017-5047).

Für die technische Herstellung dieser π-konjugierten Polymeren ist die chemische Polymerisation der monomeren Verbindungen das günstigste Verfahren. Zahlreiche Probleme treten bei diesem Verfahren auf:
1) Durch die Schwerlöslichkeit der monomeren Verbindungen in Wasser ist man häufig gezwungen, weniger umweltfreundliche organische Lösungsmittel wie z.B. Chloroform, Methylenchlorid oder Acetonitril zu verwenden.
2) Viele monomere Verbindungen erzeugen einen unangenehmen und ungesunden Geruch.
3) Die reinen oder gelösten monomeren Verbindungen sind oft unter Einwirkung von Luft und/oder Licht instabil, wodurch ein (teilweiser) Abbau stattfindet.

Überraschenderweise wurde nun gefunden, daß durch die Komplexierung der monomeren Verbindungen mit Cyclodextrinen (CD) die obengenannten Probleme bei der chemischen Polymerisation der monomeren Verbindungen vermieden werden.

Die Komplexierung von monomeren Verbindungen mit Cyclodextrinen und die nachfolgende elektrochemische Polymerisation der CD-Komplexe ist bekannt. DeFeyter et al. (Chem. Phys. Lett. 1997, 277, 44-50) untersuchten den α-Terthiophen/γ-CD-Komplex mit angeregter Dimerfluoreszenz in wäßrigen Lösungen. Dong et al. (Chin. Chem. Lett. 1992, 3(2), 129-132) polymerisierten einen Anilin/α-CD-Komplex auf elektrochemischem Wege, um eine bestimmte Theorie in bezug auf Nebenprodukte, die sich bei der elektrochemischen Entstehung von Polyanilin bilden, auszuschließen. Lasace et al. (Chem. Commun. 1998, 489; J. Chim. Phys. 1998, 95, 1208-1212) berichteten über die elektrochemische Polymerisation eines 2,2'-Bithiophen/Hydroxypropyl-β-CD-Komplexes in Wasser.

Vor kurzem hat dieselbe Gruppe von Autoren auch über die elektrochemische Polymerisation mehrerer N,N-substituierter Dipyrrolderivate berichtet, die zu Hydroxypropyl-β-CD komplexiert wurden (J. Chim. Phys. 1998, 95, 1196-1199). Chemische, bzw, elektrochemische Polymerisation von bestimmten Dipyrrol/-CD-Komplexen wird in J. MATER. CHEM.; 9, 1065 (1999), beschriben.

Keine der genannten Veröffentlichungen berichtet jedoch über die Möglichkeit der chemischen Polymerisation von Monomer/CD-Komplexen. Über die Verwendung dieser Komplexe zur Stabilisierung von monomeren Verbindungen und die sehr deutliche Verringerung des Geruches durch die Komplexierung wird ebenfalls nicht berichtet.

Gegenstand der Erfindung ist daher ein Verfahren zur Herstellung von π-konjugierten Polymeren mit mindestens den Schritten:
1. Komplexierung einer monomeren Verbindung mit einem Cyclodextrin und
2. Polymerisation der komplexierten Verbindung mit einem chemischen Oxidationsmittel.

Beispiele für monomere Verbindungen sind, Pyrrol und 3,4-Ethylendioxythiophen (EDT).

Geeignete Cyclodextrine für die Herstellung von Monomer/Cyclodextrin-Komplexen sind unsubstituierte und substituierte Cyclodextrine.

Bevorzugte Cyclodextrine sind α-, β- und γ-Cyclodextrine und deren Ester-, Alkylether-, Hydroxyalkylether-, Alkoxycarbonylalkylether- und Carboxyalkylether-Derivate oder deren Salze.

Besonders bevorzugt sind Methyl-α-cyclodextrin, Methyl-β-cyclodextrin, Methyl-γ-cyclodextrin, Ethyl-β-cyclodextrin, Butyl-α-cyclodextrin, Butyl-β-cyclodextrin, Butyl-γ-cyclodextrin, 2,6-Dimethyl-α-cyclodextrin, 2,6-Dimethyl-β-cyclodextrin, 2,6-Dimethyl-γ-cyclodextrin, 2,6-Diethyl-β-cyclodextrin, 2,6-Dibutyl-β-cyclodextrin, 2,3,6-Trimethyl-α-cyclodextrin, 2,3,6-Trimethyl-β-cyclodextrin, 2,3,6-Trimethyl-γ-cyclodextrin, 2,3,6-Trioctyl-α-cyclodextrin, 2,3,6-Trioctyl-β-cyclodextrin, 2,3,6-Triacetyl-α-cyclodextrin, 2,3,6-Triacetyl-β-cyclodextrin, 2,3,6-Triacetyl-γ-cyclodextrin, (2-Hydroxy)propyl-α-cyclodextrin, (2-Hydroxy)propyl-β-cyclodextrin, (2-Hydroxy)-propyl-γ-cyclodextrin, teilweise oder vollständig acetyliertes und succinyliertes α-, β- oder γ-Cyclodextrin, 2,6-Dimethyl-3-acetyl-β-cyclodextrin und 2,6-Dibutyl-3-acetyl-β-cyclodextrin.

Die Mono-, Di- oder Triether, Mono-, Di- oder Triester oder Monoester/-diether substituierten Derivate werden in der Regel durch Veretherung von α-, β- und γ-Cyclodextrinen mit Alkylierungsmitteln wie beispielsweise Dimethylsulfat oder Alkylhalogeniden mit 1 bis 30 C-Atomen wie beispielsweise Methyl-, Ethyl-, Propyl-, Butyl-, Pentyl-, Hexyl-, Heptyl-, Octylchlorid, -bromid oder -iodid und/oder Veresterung mit Essigsäure oder Bernsteinsäure in Gegenwart von Säuren erhalten.

Beispiele für geeignete Oxidationsmittel sind Fe(III)-Salze, insbesondere FeCl₃, H₂O₂, K₂Cr₂O₇, K₂S₂O₈, Na₂S₂O₈, KMnO₄, Alkaliperborate und Alkali- oder Ammoniumpersulfate. Weitere geeignete Oxidationsmittel sind beispielsweise in Handbook of Conducting Polymers (Ed. Skotheim, T.A.), Marcel Dekker: New York, 1986, Vol. 1, 46-57 beschrieben.

Methoden zur Herstellung der monomeren Verbindungen sind allgemein gut bekannt und beispielsweise ausführlich beschrieben in Handbook of Conducting Polymers (Ed. Skotheim, T.A.), Marcel Dekker: New York, 1986, Vol. 1, 1-43; Feast, W.J.; Tsibouklis, J.; Pouwer, K.L.; Groenendaal, L.; Meijer, E.W. Polymer 1996, 37, 5017-5047 und G. Heywang; F. Jonas Adv. Mater. 1992, 4, 116-118.

Methoden zur Herstellung von Cyclodextrinen sind ebenfalls bekannt und beispielsweise ausführlich beschrieben in "Römpp Lexikon Chemie", 10. Auflage, Stuttgart/New York 1997, S. 845 ff und Chemical Reviews 98 (1998) 1743-1753 und 1919-1958.

In einer bevorzugten Ausführungsform der Erfindung wird die Komplexierung der monomeren Verbindung in einem Molverhältnis Monomer/Cyclodextrin von 1:1-1,2 durchgeführt.

Durch das erfindungsgemäße Verfahren können die anfangs genannten Probleme vermieden werden. Je nach Cyclodextrin-Typ, können mehr oder weniger wasserlösliche Komplexe hergestellt werden, die folgende deutliche Vorteile aufweisen:
1) Die Wasserlöslichkeit des Monomers wird bei Verwendung eines oder mehrerer Moläquivalente des Cyclodextrins drastisch erhöht (z.B: läßt sich die Wasserlöslichkeit von 3,4-Ethylendioxythiophen mit 2,6-Dimethyl-β-cyclodextrin um mehr als das 30-fache erhöhen). Dies ermöglicht die Durchführung von chemischen Polymerisationen in Wasser mit viel höheren Monomerkonzentrationen.
2) Der Geruch des Monomers verschwindet bei Verwendung eines oder mehrerer Moläquivalente des Cyclodextrins, da der Dampfdruck drastisch reduziert wird.
3) In seiner im Cyclodextrin komplexierten Form verfärbt sich das Monomer unter Einwirkung von Luft und Licht nicht. Dies gilt sowohl für den in Wasser gelösten Komplex als auch für den reinen, festen Komplex.

Bemerkenswert ist, daß der Komplex sich leicht in die einzelnen Verbindungen durch Verwendung eines organischen Lösungsmittels oder Hitze auftrennen läßt. Daher bietet der Komplex eine sehr interessante Möglichkeit, empfindliche Monomere aufzubewahren und/oder zu transportieren. Weiterhin lassen sich die Monomer/Cyclodextrin-Komplexe leicht durch Techniken wie z.B. UV-Spektroskopie, Fluoreszenzspektroskopie, Infrarotspektroskopie, NMR-Spektroskopie, Massenspektroskopie, zyklische Voltammetrie und teilweise durch Röntgenstrukturanalyse charakterisieren.

Außer mit einem chemischen Oxidationsmittel können die Komplexe auch elektrochemisch polymerisiert werden.

Elektrochemische Polymerisationen können in wäßrigen Lösungen von z.B. LiClO₄ als Elektrolyt unter Verwendung einer üblichen elektrochemischen Anordnung durchgeführt werden.

Besonders wichtige Anwendungsgebiete für die nach dem erfindungsgemäßen Verfahren hergestellten π-konjugierten Polymeren sind z.B.:
- die Datenspeicherung,
- die optische Signalverarbeitung,
- die Unterdrückung elektromagnetischer Störungen (EMI),
- die Sonnenenergieumwandlung,
- wiederaufladbare Batterien,
- lichtemittierende Dioden,
- Feldeffekttransistoren,
- Sensoren,
- antistatische Materialien und
- die Durchkontaktierung von Leiterplatten und Multilayern.

Durch die besonders große Stabilität der Cyclodextrin-Komplexe sind sie für den Schutz empfindlicher monomerer Verbindungen von großem Interesse.

Ein weiterer Vorteil ist, daß sich das Cyclodextrin nach der Polymerisation des komplexierten Monomers wiederverwenden läßt.

Eine besonders wichtige Anwendungsmöglichkeit der Cyclodextrin-Komplexe ist ihr Einsatz bei der Durchkontaktierung von Leiterplatten und Multilayern.

Zwei- und mehrlagige Leiterplatten enthalten eine Vielzahl von Bohrlöchern; die metallisiert werden müssen, damit der Strom von einer Leiterbahnebene zur zweiten transportiert werden kann und herkömmliche elektronische Bauteile leitend mit der Leiterplatte verbunden werden können. Die Bohrlöcher leiten zunächst den elektrischen Strom nicht und werden daher zur Durchkontaktierung in chemischen Kupferbädem mit einer dünnen (2 bis 3 µm) Kupferschicht versehen.

In der letzten Zeit haben Verfahren an Bedeutung gewonnen, in denen auf den Einsatz-chemischer Kupferbäder verzichtet wird und in denen Kupfer direkt galvanisch auf den Bohrlochwandungen von Leiterplatten abgeschieden wird. Hierzu ist es erforderlich, die Bohrlochwandungen vor der galvanischen Abscheidung des Kupfers mit einer elektrisch leitfähigen Beschichtung auszurüsten. Diese Beschichtung muß gleichmäßig aufgetragen werden können und außerdem genügend elektrisch leitend sein, um als Basis für eine einwandfreie flächendeckende galvanische Kupferabscheidung (Durchkontaktierung) zu dienen.

Die jetzt gefundenen Cyclodextrin-Komplexe lassen sich leicht und schnell direkt auf der Leiterplatte polymerisieren.

Ein weiterer Gegenstand der Erfindung ist daher ein Verfahren zur Herstellung von durchkontaktierten Leiterplatten und Multilayem, dadurch gekennzeichnet, daß an den Wänden der Bohrlöcher durch Behandlung mit einer Lösung oder Emulsion eines Cyclodextrin-Komplexes einer monomeren Verbindung und anschließende oder gleichzeitige Säurebehandlung eine leitfähige Schicht aus einem π-konjugierten Polymeren erzeugt und auf diese ein Metall galvanisch abgeschieden wird.

Gegenüber den in der Literatur beschriebenen Verfahren, z.B. US-A-5 194 313, verhindert der Einsatz der Cyclodextrin-Komplexe, daß besonders bei der Verwendung niedrigsiedender monomerer Verbindungen die Umgebung durch verdampfende Monomere verunreinigt wird.

Es wird ein Cyclodextrin-Komplexe von Pyrrol oder 3,4-Ethylendioxythiophen verwendet.

Das erfindungsgemäße Verfahren umfaßt folgende Verfahrensschritte:
1. Herstellung von Bohrungen in den mit Kupfer kaschierten Platten (Basismaterialien)
2. Oxidative Vorbehandlung der Bohrlöcher
3. Spülen mit Wasser
4. Behandlung mit einer Lösung oder Emulsion eines Cyclodextrin-Komplexes einer monomeren Verbindung
5. Behandlung mit einer Säure
6. Spülen mit Wasser
7. Galvanische Kupferabscheidung

Die Verfahrensschritte 4 und 5 können zu einem Schritt zusammengefaßt werden. Diese Ausführungsform ist bevorzugt. Die Schritte 1, 2, 3, 6 und 7 entsprechen dem Stand der Technik und werden in an sich bekannter Weise durchgeführt. Bevorzugt wird in Schritt 2 Kaliumpermanganat als Oxidationsmittel verwendet.

Die Cyclodextrin-Komplexe können in einer Konzentration von 1 bis 60 Gew.-%, bevorzugt 10 bis 50 Gew.-%, bezogen auf die Gesamtlösung bzw. Emulsion im Verfahrensschritt 4 eingesetzt werden.

Weitere Einzelheiten des Verfahrens, insbesondere Angaben zur Art der verwendeten Säuren, Lösungsmittel und weiterer Hilfsstoffe sind bekannt und in EP-A-553 671 beschrieben.

### Beispiele

Bei den nachfolgenden Versuchen wurde ein methyliertes β-Cyclodextrin mit einem durchschnittlichen Methylierungsgrad von 1,8 pro Glucose-Einheit verwendet.

### Beispiel 1

### Herstellung eines EDT/Cyclodextrin-Komplexes:

64 g (0,45 mol) EDT werden zu einer wäßrigen Lösung von 2,6-Dimethyl-β-cyclodextrin (600 g (0,45 mol) gelöst in 1 l Wasser) gegeben. Nach wenigen Minuten erhält man eine klare Lösung. Die Komplexbildung kann durch Ultraschall oder Schütteln des Kolbens beschleunigt werden.

Der EDT/Cyclodextrin-Komplex ist sehr stabil und weitgehend gegen Oxidation geschützt. Es wird auch nach längerem Stehen an der Luft keine Verfärbung beobachtet.

### Herstellung eines Pyrrol/Cyclodextrin-Komplexes:

30,22 g (0,45 mol) Pyrrol werden zu einer wäßrigen Lösung von 2,6-Dimethyl-β-cyclodextrin (600 g (0,45 mol) gelöst in 1 I Wasser) gegeben. Nach wenigen Minuten erhält man eine klare Lösung. Die Komplexbildung kann durch Ultraschall oder Schütteln des Kolbens beschleunigt werden.

Der Pyrrol/Cyclodextrin-Komplex ist sehr stabil und weitgehend gegen Oxidation geschützt. Es wird auch nach längerem Stehen an der Luft keine Verfärbung beobachtet.

Die nachfolgende Tabelle verdeutlicht die unterschiedlichen Eigenschaften von Pyrrol und EDT auf der einen und der entsprechenden Cyclodextrin-Komplexe auf der anderen Seite. Als Cyclodextrin wurde jeweils 2,6-Dimethyl-β-cyclodextrin eingesetzt.

**Tabelle**

| | Monomer | Monomer/CD-Komplex (Molverhältnis 1:1,05) |
|---|---|---|
| Löslichkeit | Pyrrol: 50 g/l | Pyrrol: >100 g/l |
| (in Wasser bei 20°C) | EDT: 2,1 g/l | EDT: >80 g/l |
| Geruch | Pyrrol: sehr stark, unangenehm | In wäßriger Lösung: |
| | EDT: sehr stark, unangenehm | Pyrrol: minimaler Geruch |
| | | EDT: minimaler Geruch |
| | | Als Feststoff: |
| | | Pyrrol: minimaler Geruch |
| | | EDT: minimaler Geruch |
| Stabilität | Pyrrol: Verfärbung an der Luft | In wäßriger Lösung: |
| | schon nach wenigen Stunden | Pyrrol: keine Verfärbung |
| | EDT: Verfärbung an der Luft | EDT: keine Verfärbung |
| | schon nach wenigen Stunden | Als Feststoff: |
| | | Pyrrol: keine Verfärbung |
| | | EDT: keine Verfärbung |

### Beispiel 2

### Herstellung eines EDT/Cyclodextrin-Komplexes und anschließende chemischoxidative Polymerisation:

a) 10 g (7,5 mmol) 2,6-Dimethyl-β-cyclodextrin werden in 30 ml H₂O gelöst. Zu dieser Lösung werden 1,065 g (7,5 mmol) 3,4-Ethylendioxythiophen (EDT) gegeben. Die Lösung wird stark gerührt (ca. 10 Minuten) oder mit einem Ultraschallgerät behandelt (10 Sekunden), wobei eine klare, homogene Lösung resultiert. Die Bildung der Komplex-Verbindung kann mittels NMR (Verschiebungen im ¹H-NMR in D₂O von 0,2 ppm) oder Fluoreszenz-spektroskopisch (drastische Erhöhung der Fluoreszenzintensität von EDT in H₂O bei Zugabe von 2,6-Dimethyl-β-cyclodextrin) nachgewiesen werden.
b) Zu der unter a) hergestellten Lösung werden 5,0685 g (18,75 mmol) FeCl₃ x 6H₂O zugefügt und bei 70°C gerührt. Nach 12 h wird das entstandene Poly(ethylendioxythiophen) über einen Membranfilter (5 µm) abgesaugt. Der Filterrückstand wird 2 mal in 50 ml heißem Wasser resuspendiert und abgesaugt; anschließend in 50 ml Methanol resuspendiert, abgesaugt und im Vakuumtrockenofen bei 60°C 5 h getrocknet.
   Ausbeute: 0,9 g

### Beispiel 3

### Herstellung eines Pyrrol/Cyclodextrin-Komplexes und anschließende chemischoxidative Polymerisation:

a) 10 g (7,5 mmol) 2,6-Dimethyl-β-cyclodextrin werden in 30 ml H₂O gelöst. Zu dieser Lösung werden 0,5 g (7,5 mmol) Pyrrol gegeben. Diese Lösung wird stark gerührt (ca. 1 Minute), wobei eine klare, homogene Lösung resultiert. Die Bildung der Komplex-Verbindung kann mittels ¹H-NMR oder Fluoreszenz-spektroskopisch nachgewiesen werden.
b) Zu der unter a) hergestellten Lösung werden 2,53 g (9,38 mmol) K₂S₂O₈ zugefügt und bei 30°C gerührt. Nach 6 h Reaktionszeit wird das entstandene Polypyrrol über einen Membranfilter (5 µm) abgesaugt. Der Filterrückstand wird 2 mal in 50 ml heißem Wasser resuspendiert und abgesaugt; anschließend in 50 ml Methanol resuspendiert und im Vakuumtrockenofen bei 60°C 5 h getrocknet.
   Ausbeute: 0,45 g

### Beispiel 4

### Durchkontaktierung:

4 x 4 cm² große, beidseitig Kupfer-kaschierte Epoxidharzplatten mit jeweils 20 Bohrlöchern von 0,4 mm Durchmesser werden 4 Minuten in eine Lösung aus 6,5 g Kaliumpermanganat, 1 g Borsäure und 92,5 g Wasser bei 85°C getaucht. Anschließend werden die Platten mit entionisiertem Wasser gewaschen bis das Wasser farblos abläuft.

Eine Platte wird 2 Minuten in eine Lösung aus 3 g Pyrrol und 97 g Wasser getaucht (Platte A, Lösung A).

Eine zweite Platte wird 2 Minuten in eine Lösung aus 3 g Pyrrol, 65,5 g 2,6-Dimethyl-β-cyclodextrin und 97 g Wasser getaucht (Platte B, Lösung B).

Beide Platten werden dann 2 Minuten in eine 2 gew.-%ige wäßrige Polystyrolsulfonsäurelösung getaucht und anschließend mit Wasser gewaschen. Die Bohrlöcher der Platten A und B sind vollflächig mit Polypyrrol beschichtet. Zur Verkupferung werden die Platten dann in einem handelsüblichen sauren Kupferbad galvanisch verkupfert.

Die Bohrlöcher der beiden Platten sind vollflächig verkupfert.

Der erfindungsgemäße Vorteil der Verwendung von Lösung B gegenüber Lösung A wird durch folgenden Test verdeutlicht:

Je 100 ml der Lösung A und B werden in einen 2 1 Meßzylinder gegeben. Über die Lösung wird ein Filterpapierstreifen, getränkt mit 5 gew.-%iger wäßriger Eisen(III)-chloridlösung gehängt und die Meßzylinder mit einem Gummistopfen verschlossen. Im Fall der Lösung A färbt sich der Filterstreifen nach ca. 10 Sekunden durch Bildung von Polypyrrol dunkel, während bei Lösung B nach 2 Minuten noch keine Farbveränderung beobachtet wird.

Dieser Versuch zeigt, daß nach dem erfindungsgemäßen Verfahren in der Praxis unerwünschte Verdampfungsverluste vermieden werden.

## Patentansprüche

1. Verfahren zur Herstellung von π-konjugierten Polymeren mit mindestens den Schritten
1. Komplexierung einer monomeren Verbindung mit einem Cyclodextrin und
2. Polymerisation der komplexierten Verbindung mit einem chemischen Oxidationsmittel,
wobei als monomere Verbindung Pyrrol oder 3,4-Ethylendioxythiophen verwendet wird.

2. Verfahren nach Anspruch 1, **dadurch gekennzeichnet, daß** als Cyclodextrin Methyl-α-cyclodextrin, Methyl-β-cyclodextrin, Methyl-γ-cyclodextrin, Ethyl-β-cyclodextrin, Butyl-α-cyclodextrin, Butyl-β-cyclodextrin, Butyl-γ-cyclodextrin, 2,6-Dimethyl-α-cyclodextrin, 2,6-Dimethyl-β-cyclodextrin, 2,6-Dimethyl-γ-cyclodextrin, 2,6-Diethyl-β-cyclodextrin, 2,6-Dibutyl-β-cyclodextrin, 2,3,6-Trimethyl-α-cyclodextrin, 2,3,6-Trimethyl-β-cyclodextrin, 2,3,6-Trimethyl-γ-cyclodextrin, 2,3,6-Trioctyl-α-cyclodextrin, 2,3,6-Trioctyl-β-cyclodextrin, 2,3,6-Triacetyl-α-cyclodextrin, 2,3,6-Triacetyl-β-cyclodextrin, 2,3,6-Triacetyl-γ-cyclodextrin, (2-Hydroxy)propyl-α-cyclodextrin, (2-Hydroxy)propyl-β-cyclodextrin, (2-Hydroxy)propyl-γ-cyclodextrin, teilweise oder vollständig acetyliertes und succinyliertes α-, β- oder γ-Cyclodextrin, 2,6-Dimethyl-3-acetyl-β-cyclodextrin und 2,6-Dibutyl-3-acetyl-β-cyclodextrin verwendet wird.

3. Verfahren zur Herstellung von durchkontaktierten Leiterplatten und Multilayern, **dadurch gekennzeichnet, daß** an den Wänden der Bohrlöcher durch Behandlung mit einer Lösung oder Emulsion eines Cyclodextrin-Komplexes von Pyrrol oder 3,4-Ethylendioxythiophen und anschließende oder gleichzeitige Säurebehandlung eine leitfähige Schicht aus einem π-konjugierten Polymeren erzeugt und auf diese ein Metall galvanisch abgeschieden wird.

4. Verfahren nach Anspruch 3, **dadurch gekennzeichnet, daß** es folgende Verfahrensschritte umfaßt:
1. Herstellung von Bohrungen in den mit Kupfer kaschierten Platten (Basismaterialien)
2. Oxidative Vorbehandlung der Bohrlöcher
3. Spülen mit Wasser
4. Behandlung mit einer Lösung oder Emulsion eines Cyclodextrin-Komplexes von Pyrrol oder 3,4-Ethylendioxythiophen
5. Behandlung mit einer Säure
6. Spülen mit Wasser
7. Galvanische Kupferabscheidung

5. Verfahren nach Anspruch 4, **dadurch gekennzeichnet, daß** die Verfahrensschritte 4 und 5 zusammengefaßt werden.

## Claims

1. Process for the preparation of π-conjugated polymers having at least the steps of
1. complexing of a monomeric compound with a cyclodextrin, and
2. polymerization of the complexed compound using a chemical oxidant,
wherein the monomeric compound used is pyrrole or 3,4-ethylenedioxythiophene.

2. Process according to Claim 1, **characterized in that** the cyclodextrin used is methyl-α-cyclodextrin, methyl-β-cyclodextrin, methyl-γ-cyclodextrin, ethyl-β-cyclodextrin, butyl-α-cyclodextrin, butyl-β-cyclodextrin, butyl-γ-cyclodextrin, 2,6-dimethyl-α-cyclodextrin, 2,6-dimethyl-β-cyclodextrin, 2,6-dimethyl-γ-cyclodextrin, 2,6-diethyl-β-cyclodextrin, 2,6-dibutyl-β-cyclodextrin, 2,3,6-trimethyl-α-cyclodextrin, 2,3,6-trimethyl-β-cyclodextrin, 2,3,6-trimethyl-γ-cyclodextrin, 2,3,6-trioctyl-α-cyclodextrin, 2,3,6-trioctyl-β-cyclodextrin, 2,3,6-triacetyl-α-cyclodextrin, 2,3,6-triacetyl-β-cyclodextrin, 2,3,6-triacetyl-γ-cyclodextrin, (2-hydroxy)propyl-α-cyclodextrin, (2-hydroxy)propyl-β-cyclodextrin, (2-hydroxy)-propyl-γ-cyclodextrin, partially or fully acetylated and succinylated α-, β- or γ-cyclodextrin, 2,6-dimethyl-3-acetyl-β-cyclodextrin and 2,6-dibutyl-3-acetyl-β-cyclodextrin.

3. Process for the production of through-contacted circuit boards and multilayers, **characterized in that** a conductive layer of a π-conjugated polymer is formed on the walls of the drilled holes by treatment with a solution or emulsion of a cyclodextrin complex of pyrrole or 3,4-ethylenedioxythiophene and subsequent or simultaneous acid treatment, and a metal is deposited on this layer by electroplating.

4. Process according to Claim 3, **characterized in that** it comprises the following process steps:
1. Production of drilled holes in the copper-laminated boards (base materials)
2. Oxidative pre-treatment of the drilled holes
3. Rinsing with water
4. Treatment with a solution or emulsion of a cyclodextrin complex of pyrrole or 3,4-ethylenedioxythiophene
5. Treatment with an acid
6. Rinsing with water
7. Deposition of copper by electroplating.

5. Process according to Claim 4, **characterized in that** process steps 4 and 5 are combined.

## Revendications

1. Procédé pour la préparation de polymères π-conjugués, qui comprend au moins les stades opératoires suivants :
1. Complexation d'un composé monomère par une cyclodextrine et
2. Polymérisation du composé complexé à l'aide d'un agent oxydant chimique,
le composé monomère utilisé consistant en le pyrrole ou le 3,4-éthylène-dioxythiophène.

2. Procédé selon la revendication 1, **caractérisé en ce que** la cyclodextrine utilisée est la méthyl-α-cyclodextrine, la méthyl-β-cyclodextrine, la méthyl-γ-cyclodextrine, l'éthyl-β-cyclodextrine, la butyl-α-cyclodextrine, la butyl-β-cyclodextrine, la butyl-γ-cyclodextrine, la 2,6-diméthyl-α-cyclodextrine, la 2,6-diméthyl-β-cyclodextrine, la 2,6-diméthyl-γ-cyclodextrine, la 2,6-diéthyl-β-cyclodextrine, la 2,6-dibutyl-β-cyclodextrine, la 2,3,6-triméthyl-α-cyclodextrine, la 2,3,6-triméthyl-β-cyclodextrine, la 2,3,6-triméthyl-γ-cyclodextrine, la 2,3,6-trioctyl-α-cyclodextrine, la 2,3,6-trioctyl-β-cyclodextrine, la 2,3,6-triacétyl-α-cyclodextrine, la 2,3,6-triacétyl-β-cyclodextrine, la 2,3,6-triacétyl-γ-cyclodextrine, la (2-hydroxy)-propyl-α-cyclodextrine, la (2-hydroxy)propyl-β-cyclodextrine, la (2-hydroxy)propyl-γ-cyclodextrine, l'α-, la β- ou la γ-cyclodextrine partiellement ou totalement acétylées et succinylées, la 2,6-diméthyl-3-acétyl-β-cyclodextrine et la 2,6-dibutyl-3-acétyl-β-cyclodextrine.

3. Procédé pour la fabrication de plaques conductrices et dispositifs à couches multiples en contact électrique mutuel, **caractérisé en ce que**, sur les parois des orifices, et par traitement à l'aide d'une solution ou d'une émulsion d'un complexe de cyclodextrine du pyrrole ou du 3,4-éthylène-dioxythiophène avec traitement subséquent ou simultané à l'aide d'un acide, on forme une couche conductrice d'un polymère π-conjugué et sur cette couche, on dépose un métal par électrolyse.

4. Procédé selon la revendication 3, **caractérisé en ce qu'**il comprend les stades opératoires :
1. Perforation d'orifices dans les plaques doublées de cuivre (matériau de base)
2. Traitement préalable des orifices par oxydation
3. Rinçage à l'eau
4. Traitement à l'aide d'une solution ou d'une émulsion d'un complexe de cyclodextrine du pyrrole ou du 3,4-éthylène-dioxythiophène
5. Traitement à l'aide un acide
6. Rinçage à l'eau
7. Déposition électrolytique de cuivre.

5. Procédé selon la revendication 4, **caractérisé en ce que** l'on combine les stades opératoires 4 et 5 en un seul stade opératoire.
